(19) **Europäisches Patentamt**
**European Patent Office**
**Office européen des brevets**

(11) **EP 1 812 949 B1**

(12) **EUROPEAN PATENT SPECIFICATION**

(45) Date of publication and mention
of the grant of the patent:
**07.07.2010 Bulletin 2010/27**

(51) Int Cl.:
***H01J 37/32*** *(2006.01)*

(21) Application number: **05801054.7**

(22) Date of filing: **11.11.2005**

(86) International application number:
**PCT/CH2005/000669**

(87) International publication number:
**WO 2006/050632 (18.05.2006 Gazette 2006/20)**

(54) **IMPEDANCE MATCHING OF A CAPACITIVELY COUPLED RF PLASMA REACTOR SUITABLE FOR LARGE AREA SUBSTRATES**

IMPEDANZANPASSUNG EINES KAPAZITIV GEKOPPELTEN HF-PLASMAREAKTORS MIT EIGNUNG FÜR GROSSFLÄCHIGE SUBSTRATE

REACTEUR A PLASMA RF A COUPLAGE CAPACITIF

(84) Designated Contracting States:
**AT BE BG CH CY CZ DE DK EE ES FI FR GB GR HU IE IS IT LI LT LU LV MC NL PL PT RO SE SI SK TR**

(30) Priority: **12.11.2004 US 627784 P**

(43) Date of publication of application:
**01.08.2007 Bulletin 2007/31**

(73) Proprietor: **Oerlikon Trading AG, Trübbach 9477 Trübbach (CH)**

(72) Inventor: **BELINGER, Andy CH-9478 Azmoos (CH)**

(56) References cited:
**GB-A- 2 058 470** **US-A- 3 471 396**
**US-A1- 2003 098 127** **US-A1- 2004 035 365**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

This application claims the benefit of U.S. Provisional Patent Application No. 60/627,784 filed on November 12, 2004.

**FIELD OF THE INVENTION**

The present invention relates in general to RF capacitive coupled plasma reactors for processing a very large area display. More specifically, the present invention relates to improvements in the coupling efficiency of the RF power delivered to plasma typically at a frequency of 13.56MHz or less.

**BACKGROUND OF THE INVENTION**

The present invention is based on problems and requirements that have arisen in depositing semi-conductive layers on very large glass areas for the display and solar manufacturing industries. The resulting solution, however, can be applied to other applications. Thus, even though the present invention will be described relating to plasma reactors for Plasma Enhanced Chemical Vapor Deposition (PECVD) systems for very large area display processing, the present invention can also be applied to other applications relating to plasma reactors. Further, the development of PECVD for very large area display processing is disclosed in U.S. Pat. No. 6,281,469.

GB 2 058 470 describes a RF sputtering apparatus with a power transfer network for coupling a source of RF energy to a physically large (>50 cm2) dimensioned electrode system. For more efficient power transfer a string of at least three resonant networks is arranged between the RF source and the electrodes ansd these networks transform impedance and voltage values from one end of the string at the source to different values at the other end.

US 2004/0035365 A1 describes a plasma processing apparatus including first and second electrodes opposing each other in a process chamber. An RF power supply is connected to the first or second electrode through a matching circuit automatically performing input impedance matching relative to the RF power.

US 2003/0098127A1 refers to a plasma processing apparatus including a matching circuit for impedance matching between a RF generator and a plasma processing chamber and one or a plurality of impedance converting circuits provided between the matching circuit and the RF generator.

US 3,471,396 adresses an apparatus for the RF sputtering of both dielectric and conductive materials in a plasma. The RF power supply is connected through an impedance matching circuit to an electrode associated with the the material to be sputtered, located in the chamber to produce the glow discharge.

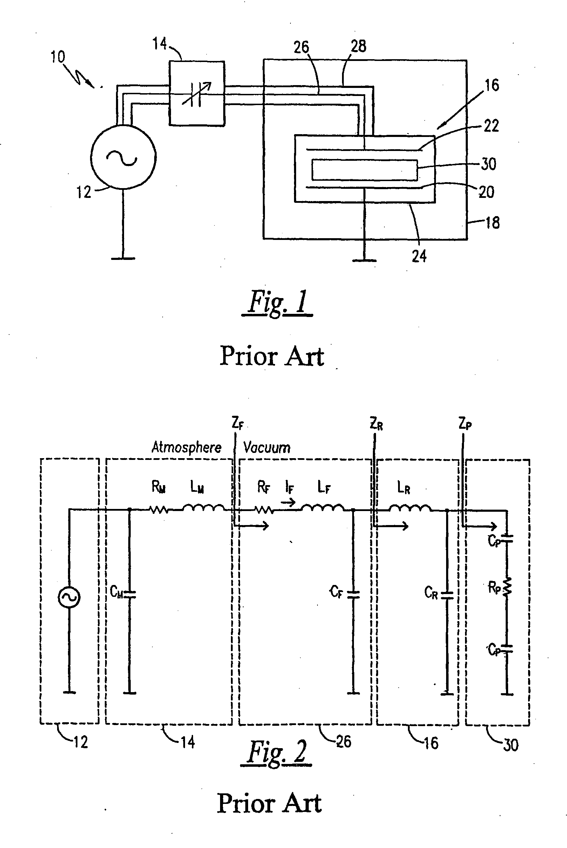

FIGURE 1 shows a conventional capacitively-coupled, RF-plasma reactor system 10 for a PECVD system. The reactor system 10 includes an RF power supply 12, a matching network 14, a reactor chamber 16, and a vacuum chamber 18. The reactor chamber 16 includes two metallic plates 20, 22 arranged in parallel enclosed in a metallic-reactor casing 24. The first metallic plate 22 is electrically connected to the RF power supply 12 via a feeding element 26 and the matching network 14 and the first metallic plate 22 is, thus, a live electrode. The second metallic plate 20 is connected to ground and is, thus, a ground electrode. During the deposition process a substrate is placed on the second metallic plate 20 for processing. The feeding element 26 is shielded with a grounding shield 28 and can be any type of electrical feeding element known in the art, such as an RF stripline, RF ribbon, or a triplate stripline. A plasma-discharge region 30 is defined in between the two metallic plates 20, 22. As shown in FIGURE 1, the RF power supply 12 and matching network 14 are located outside the vacuum chamber 18 and the reactor chamber 16 and feeding element 26 are located inside the vacuum chamber 18. Thus, during the deposition process, the RF power supply 12 and the matching network 14 are under atmospheric conditions and the reactor chamber 16 and RF feed line 28 are under vacuum conditions. A typical gas used for forming a plasma in the PECVD process is a silicon nitride SiN gas. Other gases commonly known in the art, however, may be used in this type of application such as organometallics, hydrides and halides.

FIGURE 2 shows a simplified equivalent circuit of the conventional PECVD system during the deposition of SiN and will be used to illustrate the disadvantage of the conventional RF-plasma reactor system 10. The dotted line boxes represent a portion of the conventional RF-plasma reactor system 10 as indicated by the reference numbers. During the deposition process, in the conventional RF-plasma reactor, several kilowatts of RF power at a radio frequency of 13.56 MHz must be delivered to the plasma in order to achieve the necessary deposition rate and maintain a reasonable throughput. A disadvantage to this process in large area parallel plate reactors is that a very large parasitic-reactor capacitance $C_R$, typically greater than 5000pF, forms between the live electrode 22 and the grounded reactor casing 24. Thus, the feeding element 26 must be capable of handling very large RF currents IF, typically greater than 300A. The large RF currents require a very wide stripline design, which leads to a second parasitic-feed-line capacitance $C_F$ between the live wire of the feeding element 26 and the grounding shield 28. The feed-line capacitance $C_F$ is typically greater than 3000pF. The reactor $C_R$ and feed-line $C_F$ capacitance transform a plasma impedance $Z_P$ to a feed-through impedance $Re(Z_F)$ having a very small value, typically less than 0.05 ohms. The feed-through impedance $Re(Z_F)$ is the impedance as seen at the entrance of the vacuum chamber 18 where the feeding element 26 enters the vacuum chamber 18. The feed-through impedance $Re(Z_F)$ in turn creates a larger RF current IF, typically greater than 400A, which now must be accommodated by the matching network 14 and the feeding element 26. As a result, most of the power delivered by the RF power supply is dissipated in the lossy elements $R_M$, $R_F$ of the matching network 14 and the feeding element 26 respectively. Thus, the efficiency of the system is low, typically ηs<0.3. Therefore, very large and expensive RF power supplies are required in order to achieve the necessary plasma power density and deposition rate. Further, as the size of the glass increases the efficiency of the plasma power coupling efficiency decreases to values less than 20% at an RF frequency of 13.56MHz.

There have been several solutions to address the above mentioned problem but each have additional disadvantages. For example, the parasitic capacitance $C_R$ and $C_F$ could be reduced by increasing the gap between the live parts, i.e. the live electrode 22 and feeding element 26, and the grounded parts, i.e. the reactor casing 24 and the ground shield 28. The disadvantage to this solution, however, is that the plasma between the gaps could ignite. Another solution is to water cool the reactor. This, however, is difficult in a vacuum system and water cooling does not significantly enhance the plasma coupling efficiency.

Another solution is adding an impedance-transformation circuit to the RF-plasma reactor system 10. Power losses through the lossy elements $R_M$, $R_F$ in the matching network 14 and the feeding element 26 respectively can be reduced by decreasing the RF current IF. Reducing the RF current IF while maintaining the plasma power can be accomplished with an impedance-transformation circuit, which increases the feed-through impedance $Re(Z_F)$. In theory, connecting an inductor between the live electrode and ground will suffice as an impedance-transformation circuit. But an impedance-transformation circuit solely made of one inductor is impractical for several reasons. For example, the inductor needs to be a low-loss inductor, there is nothing to prevent the DC voltage from shorting to ground, and there is no tuning capability.

Thus, what is desired is a practical impedance-transformation circuit for an RF capacitive coupled plasma reactor for processing very large substrates that overcomes the above mentioned disadvantages.

## BRIEF SUMMARY OF THE INVENTION

The present invention is defined by the subject-matter of claim 1. A plasma reactor is described comprising, a vacuum chamber, a first metallic plate and a second metallic plate located inside the vacuum chamber, an RF power supply, a matching network, a plasma-discharge region containing plasma defined between the first and second metallic plates, a feeding element electrically connected to the first metallic plate, and an impedance-transformation circuit electrically connected to the first metallic plate.

Moreover, a plasma reactor is provided comprising, a vacuum chamber, an RF power supply, a matching network, a first metallic plate and a second metallic plate located inside the vacuum chamber, a plasma-discharge region for containing plasma defined between the first and second metallic plates, a feeding element electrically connected to the first metallic plate, an impedance-transformation circuit electrically connected to the first metallic plate, comprising an isolation capacitor, later referred as blocking capacitor.

Further, a method of depositing semi-conductive layers in a vacuum is provided comprising the steps of, providing a plasma reactor further including an RF power supply, a vacuum chamber, a reactor chamber, having a reactor impedance, located inside the vacuum chamber, a first and second metallic plate located inside the vacuum chamber; a plasma-discharge region for containing plasma defined between the first and second metallic plates, a feeding element electrically connected to the first metallic plate, and an impedance-transformation circuit electrically connected to the first metallic plate, placing a substrate on the second metallic plate, delivering RF power to the plasma, transforming the reactor impedance to an intermediate impedance with the impedance-transformation circuit, and transforming the intermediate impedance to a feed-through impedance with the feeding element, whereby the feed-through impedance is increased.

Benefits and advantages of the present invention will become apparent to those skilled in the art to which it pertains upon a reading and understanding of the following detailed specification.

## BRIEF DESCRIPTION OF THE DRAWINGS

The invention may take physical form in certain parts and arrangement of parts, a preferred embodiment of which will be described in detail in this specification and illustrated in the accompanying drawings that form a part of the specification.

FIGURE 1 is a schematic of a conventional capacitor-coupled, RF-plasma reactor system.

FIGURE 2 is an equivalent circuit of the reactor system of FIGURE 1.

FIGURE 3 is a schematic of a capacitor-coupled, RF-plasma reactor system with an impedance-transformation circuit in accordance with the present invention.

FIGURE 4 is an equivalent circuit of the reactor system of FIGURE 3.

FIGURE 5 is a graph showing the comparison of the impedance transformation between the conventional circuit of FIGURE 2 and circuit with the impedance-transformation circuit of FIGURE 4.

## DETAILED DESCRIPTION OF THE INVENTION

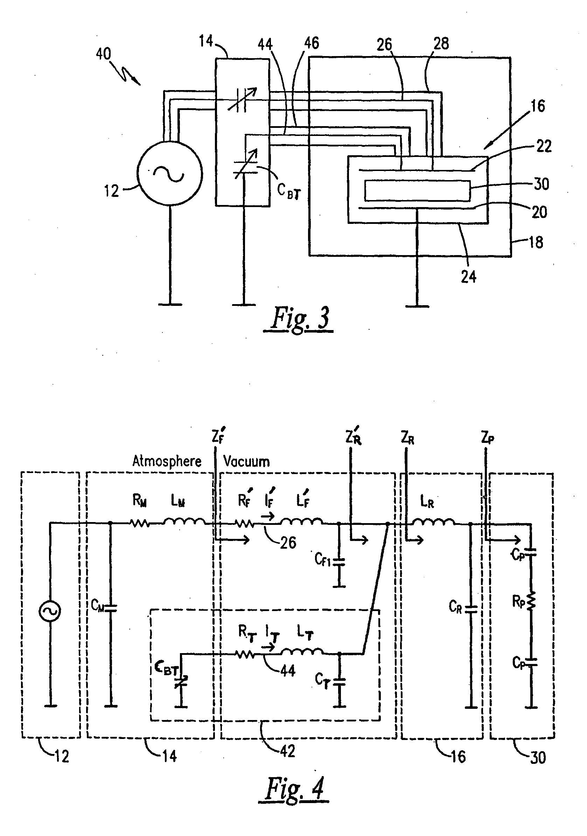

Referring now to FIGURES 3 and 4, a more practical impedance-transformation circuit is shown in the schematic in FIGURE 3 and the electrical equivalent circuit in FIGURE 4. All components described in FIGURES 1 and 2 above that are the same in FIGURES 3 and 4 will not be repeated.

FIGURE 3 shows a capacitively-coupled, RF-plasma reactor system 40 (hereinafter "transformed RF-plasma reactor system") for a PECVD system having an impedance-transformation circuit 42, shown in FIGURE 4, in accordance with the present invention. The impedance-transformation circuit 42 includes a transformation circuit feeding element 44 with a grounding shield 46 and a tuneable-blocking capacitor $C_{BT}$.

Referring to FIGURE 4, the second feeding element 44 is represented in the equivalent circuit as having parasitic capacitance $C_T$, a lossy element $R_T$, and an low-loss inductor $L_T$. The transformation circuit feeding element 44 is located inside the vacuum chamber 18 and is connected to ground via the tuneable-blocking capacitor $C_{BT}$. Thus, with the addition of the impedance-transformation circuit 42, the transformed RF-plasma reactor system 40 now includes the feeding element 26 and the transformation circuit feeding element 44 both of which are electrically connected to the first metallic plate 22. The tuneable-blocking capacitor $C_{BT}$ is located outside the vacuum chamber 18 and can be integrated into the matching network 14, resulting in amended matching network 14' (Fig. 3). The tuneable-blocking capacitor $C_{BT}$ can increase the feed-through impedance $Re(Z_F')$ thereby decreasing the total RF current IF' during the deposition process. Further, the tuneable-blocking capacitor $C_{BT}$ can balance the current between the two feeding elements 26, 44 without venting the system.

The following equations illustrate the effect of the impedance-transformation circuit 42 relating to power loss. First, in the conventional RF plasma reactor system 10, the current IF flowing out of the matching network 14 and through the feeding element 26 with no impedance-transformation circuit 42, as shown in FIGURES 1 and 2, is approximately:

$$(1) \qquad \qquad I_F = sqrt[P_F/Re(Z_F)]$$

for an RF signal having a wavelength greater than the diameter of the electrode or longer than the feeding line and where $P_F$ is the power at the output of the matching network 14, which is dissipated through the lossy elements $R_M$ and Rp in the feeding element 26 and the plasma. The power lost through the lossy elements $R_M$ and $R_F$ in the matching network 14 and feeding element 26 is defined by the following equation:

$$(2) \qquad \qquad P_{Loss1} = I_F^2(R_M+R_F)$$

The efficiency of the matching network 14 is defined by:

$$(3) \qquad \qquad \eta_{MB} = Re(Z_F)/[Re(Z_F)+R_M]$$

Further, the efficiency of an L-type or T-type matching network is .given through:

$$(4) \qquad \qquad \eta = Q_U/(Q_U+Q_L)$$

where $Q_U$ is the unloaded quality factor of lumped elements and $Q_L$ is the loaded quality factor of the lumped elements.

With the addition of the impedance-transformation circuit 42, as shown in FIGURES 3 and 4, the current $I_F'$ flowing out of the matching network 14 and through the feeding element 26 is partially compensated by the current $I_T$ flowing through the transformation circuit element 44 and tuneable-blocking capacitor $C_{BT}$. The optimal balance between IF'and $I_T$ can be adjusted through the timeable-blocking capacitor $C_{BT}$ and depends on the balance between the power losses of the lossy elements $(R_F'+R_M)$ of the feeding element 26 and matching network 14 and the lossy element $R_T$ of the transformation circuit feeding element 44. The total losses in the matching network 14 and the feeding element 26 and transformation circuit feeding element 44 is defined as:

$$(5) \qquad P_{Loss2} = I_F'^2(R_M + R_F') + I_T^2 R_T$$

for an RF signal having a wavelength greater than the diameter of the electrode or longer than the feeding line. If the tuneable-blocking capacitor $C_{BT}$ is adjusted such that the currents IF', $I_T$ are equal then $I_F'=I_T=I_F/2$. Further, if the currents IF', $I_T$ are equal and if the lossy elements $R_M$, $R_F'$, $R_T$, and $R_F$ are also equal, thus, $R_M=R_F'=R_T=R_F$. Thus, if $I_F'$, IT are equal $P_{Loss1}$ becomes:

$$(6) \qquad P_{Loss1} = I_F^2(R_M + R_F) = 2I_F^2 R_F$$

and $P_{Loss2}$ becomes:

$$(7) \qquad P_{Loss2} = I_F'^2(R_M + R_F') + I_T^2 R_T = (3/4)I_F^2 R_F.$$

Thus, the loss ratio between the conventional RF-plasma reactor system 10 (no impedance-transformation circuit 42) and the transformed RF-plasma reactor system 40 with the impedance-transformation circuit 42 is:

$$(6) \qquad P_{Loss1}/P_{Loss2} = (2I_F^2 R_F)/(3/4)I_F^2 R_F = 8/3.$$

As these equations illustrate, the power lost through the lossy elements $R_M$, $R_F$ in the conventional RF-plasma reactor system 10 (no impedance-transformation circuit 42) are more than twice as much as the power lost through the lossy elements $R_M$, $R_F'$, $R_T$ in the transformed RF-plasma reactor system 40 with the impedance-transformation circuit 42. Thus, because the power loss decreases in the transformed RF-plasma reactor system 40 with the impedance-transformation circuit 42, the power delivered to the plasma to maintain the same deposition rate as the conventional RF-plasma reactor system 10 (no impedance-transformation circuit 42) can be reduced. Thus, a smaller RF power supply can be used to achieve the same deposition rate. On the other hand, if the same size RF power supply is used the deposition rate will increase thereby increasing throughput.

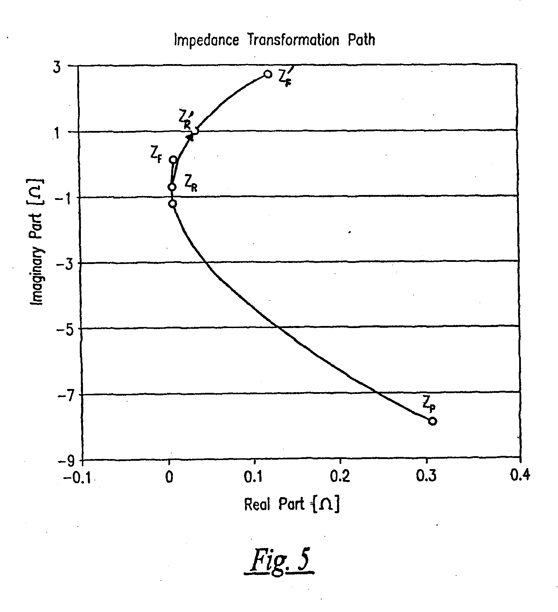

FIGURE 5 shows a graph that illustrates how the impedance-transformation circuit 42 transforms the feed-through impedance $Re(Z_F')$ to thereby decrease the power lost through the lossy elements. In the conventional RF-plasma reactor system 10 the plasma impedance Zp is transformed by a reactor capacitance $C_R$ and a reactor inductance $L_R$ to a reactor impedance $Z_R$ located at the end of the feeding element 26. The feeding element 26 then transforms the reactor impedance $Z_R$ to a feed-through impedance designated as $Z_F$. In the transformed RF-plasma reactor system 40 the plasma impedance $Z_P$ is transformed to the reactor impedance $Z_R$ just as in the conventional RF-plasma reactor system 10. The impedance-transformation circuit 42, however, transforms the reactor impedance $Z_R$ to an intermediate impedance $Z_R'$. The feeding element 26 then transforms the intermediate impedance $Z_R'$ to a feed-through impedance designated as $Z_F$. As illustrated in FIGURE 5, the feed-through impedance $Z_F$ has both a higher resistive or real part and a higher inductive reactive or imaginary part than the feed-through impedance $Z_F$. In other words, $Re(Z_F') > Re(Z_F)$ and $Im(Z_F) > Im(Z_F)$. More specifically, the real part of the feed-through impedance $Re(Z_F)$ is approximately 0.1 to 0.2 ohms whereas the real part of the feed-through impedance $Re(Z_F)$ is approximately 0.0 to 0.1 ohms. The imaginary part of the feed-through impedance $Im(Z_F)$ is approximately 1 to 5 ohms whereas the imaginary part of the feed-through impedance $Im(Z_F)$ is approximately -3 to 1 ohms. Further, the impedance-transformation circuit 42 is not intended to compensate for reactive impedance or cancel out phase shifts. The more inductive the feed-through impedance $Z_F$, however, the less inductance is required in the matching network. As a result, the quality of the matching network can be enhanced even more because the RF power losses are mainly associated with lumped elements such as inductors made from copper.

While specific embodiments of the invention have been described and illustrated, it is to be understood that these embodiments are provided by way of example only and that the invention is not to be construed as being limited thereto but only by proper scope of the following claims.

## Claims

1. An RF plasma reactor comprising:

   a vacuum chamber (18); a RF power supply (12); a matching network (14);
   a first metallic plate (22) and a second metallic plate (20) located inside the vacuum chamber;
   a plasma-discharge region (30) defined between the first and second metallic, plates;
   a feeding element (26) electrically connected to the first metallic plate (22), the matching network (14) and the RF power supply (12); and,
   an impedance-transformation circuit (42) electrically connected to the first metallic plate (22) and comprising a transformation circuit feeding element (44) electrically connected to the first metallic plate (22) and a blocking-tunable capacitor $C_{BT}$ electrically connected to ground,
   wherein the feeding element (26) and the transformation circuit feeding element (44), are located inside the vacuum chamber (18) and **characterised in that** the blocking-tunable capacitor $C_{BT}$ is located outside the vacuum chamber (18).

2. The plasma reactor according to claim 1, wherein the first metallic plate (22) is electrically connected to an RF power supply (12), the second metallic plate (20) is electrically connected to ground, and the impedance-transformation circuit (42) is electrically connected to ground.

3. The plasma reactor according to claim 2, wherein the feeding element (26) is electrically connected to an RF power supply (12) and the transformation circuit feeding element (44) is electrically connected to ground and the second metallic plate (20) is electrically connected to ground.

## Patentansprüche

1. Ein RF-Plasmareaktor, umfassend:

   eine Vakuumkammer (18); eine RF-Stromversorgung (12); ein passendes Leitungsnetz (14);
   eine erste Metallplatte (22) und eine zweite Metallplatte (20), befindlich im Inneren der Vakuumkammer;
   einen zwischen der ersten und zweiten Metallplatte befindlichen Plasma-Austrittsbereich (30);
   ein mit der ersten Metallplatte (22) elektrisch verbundenes Versorgungselement (26), das entsprechende Leitungsnetz (14) sowie die RF-Stromversorgung (12); und
   eine mit der ersten Metallplatte (22) elektrisch verbundene Impedanztransformationsschaltung (42), die ein Versorgungselement der Transformationsschaltung (44) umfasst, das elektrisch mit der ersten Metallplatte (22) verbunden ist, sowie einen justierbaren Sperrkondensator $C_{BT}$ mit elektrischer Erdung,
   wobei das Versorgungselement (26) und das Versorgungselement (44) der Transformationsschaltung innerhalb der Vakuumkammer (18) liegen, und **dadurch gekennzeichnet, dass** der justierbare Sperrkondensator $C_{BT}$ außerhalb der Vakuumkammer (18) positioniert ist.

2. Der Plasmareaktor gemäß Anspruch 1, wobei die erste Metallplatte (22) elektrisch mit der RF-Stromversorgung (12) verbunden, die zweite Metallplatte (20) elektrisch geerdet und die Impedanztransformationsschaltung (42) elektrisch geerdet ist.

3. Der Plasmareaktor gemäß Anspruch 2, wobei das Versorgungselement (26) elektrisch mit einer RF-Stromversorgung (12) verbunden, das Versorgungselement der Transformationsschaltung (44) elektrisch geerdet und die zweite Metallplatte (20) elektrisch geerdet ist.

**Revendications**

1. Réacteur à plasma RF comprenant :

   une chambre à vide (18) ; une alimentation de puissance RF (12) ; un réseau d'adaptation (14) ;
   une première plaque métallique (22) et une seconde plaque métallique (20) placée à l'intérieur de la chambre à vide ;
   une région de décharge à plasma (30) située entre les première et seconde plaques métalliques ;
   un élément d'alimentation (26) raccordé électriquement à la première plaque métallique (22), au réseau d'adaptation (14) et à l'alimentation de puissance RF (12) ; et,
   un circuit de transformation d'impédance (42) raccordé électriquement à la première plaque métallique (22) et comprenant un élément d'alimentation de circuit de transformation (14) raccordé électriquement à la première plaque métallique (22) et un condensateur de blocage accordable $C_{BT}$ raccordé électriquement à la terre,
   l'élément d'alimentation (26) et l'élément d'alimentation de circuit de transformation (44) étant disposés à l'intérieur de la chambre à vide (18) et **caractérisé en ce que** le condensateur de blocage accordable $C_{BT}$ est situé à l'extérieur de la chambre à vide (18).

2. Réacteur à plasma selon la revendication 1, dans lequel la première plaque métallique (22) est raccordée électriquement à une alimentation de puissance RF (12), la seconde plaque métallique (20) est raccordée électriquement à la terre, et le circuit de transformation d'impédance (42) est raccordé électriquement à la terre.

3. Réacteur à plasma selon la revendication 2, dans lequel l'élément d'alimentation (26) est raccordé électriquement à une alimentation de puissance RF (12) et l'élément d'alimentation de circuit transformation (44) est raccordé électriquement à la terre et la seconde plaque métallique (20) est raccordée électriquement la terre.

*Fig. 1*

Prior Art

*Fig. 2*

Prior Art

_Fig. 3_

_Fig. 4_

Impedance Transformation Path

Fig. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 62778404 P
- US 6281469 B
- GB 2058470 A
- US 20040035365 A1
- US 20030098127 A1
- US 3471396 A